# FASCICULE DE BREVET EUROPEEN

(11) **EP 3 769 339 B1**
(45) Date de publication et mention de la délivrance du brevet: **23.02.2022**
(21) Numéro de dépôt: 19717543.3
(22) Date de dépôt: 18.03.2019
(51) Int. Cl.: H01L 27/15, H01L 33/38

(54) **DISPOSITIF D'AFFICHAGE EMISSIF A LED ET PROCEDE DE FABRICATION D'UN TEL DISPOSITIF**
LED-EMISSIVE ANZEIGEVORRICHTUNG UND VERFAHREN ZUR HERSTELLUNG SOLCH EINER VORRICHTUNG
LED EMISSIVE DISPLAY DEVICE AND METHOD FOR PRODUCING SUCH A DEVICE

(30) Priorité: 22.03.2018 FR 1852465
(43) Date de publication de la demande: 27.01.2021
(73) Titulaire: Commissariat à l'Energie Atomique et aux Energies Alternatives, 75015 Paris (FR)
(72) Inventeur: TEMPLIER, François, 38054 GRENOBLE CEDEX 9 (FR); CHERAMY, Séverine, 38054 GRENOBLE CEDEX 9 (FR); FOURNEL, Frank, 38054 GRENOBLE CEDEX 9 (FR)
(74) Mandataire: Cabinet Beaumont
(86) Numéro de dépôt international: PCT/FR2019/050608
(87) Numéro de publication internationale: WO 2019/180362

(56) Documents cités:
- EP-A1- 3 024 030
- WO-A1-2017/068029

## Description

La présente demande de brevet revendique la priorité de la demande de brevet français FR18/52465.

### Domaine

La présente demande concerne le domaine des dispositifs optoélectroniques. Elle concerne plus particulièrement un dispositif d'affichage émissif à diodes électroluminescentes (LED), aussi appelé micro-écran à LED, et un procédé de fabrication d'un tel dispositif.

### Exposé de l'art antérieur

On a déjà proposé un dispositif d'affichage émissif comportant un ensemble de plusieurs LED, par exemple au nitrure de gallium, et un circuit de contrôle permettant de commander individuellement les LED pour afficher des images.

On s'intéresse ici plus particulièrement au cas où le circuit de contrôle est intégré dans et sur un substrat semiconducteur, par exemple un substrat de silicium, par exemple en technologie CMOS.

Pour réaliser un tel dispositif, on peut prévoir de fabriquer séparément le circuit de contrôle et l'ensemble de LED, puis de les connecter l'un à l'autre pour former le dispositif d'affichage. Du côté d'une de ses faces, le circuit de contrôle comprend une pluralité de plots métalliques, chaque plot étant destiné à être connecté à une électrode d'une LED de l'ensemble de LED, pour pouvoir commander les LED individuellement. L'ensemble de LED est par exemple réalisé de façon monolithique sur un substrat de support, puis rapporté sur le circuit de contrôle de façon que chaque LED ait une électrode (anode ou cathode) connectée à l'un des plots métalliques du circuit de contrôle.

Une difficulté réside dans la nécessité d'aligner précisément le circuit de contrôle et l'ensemble de LED lors de l'étape d'assemblage de ces deux éléments, de façon que chaque LED vienne bien se positionner sur le plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels. Les documents EP 3 024 030 A1, WO 2017/068029 A1, et WO 2016/060676 A1 divulguent des dispositifs d'affichage comportant une pluralité de diodes électroluminescentes.

### Résumé

Ainsi, un mode de réalisation prévoit un dispositif d'affichage comprenant un premier circuit intégré comportant :
un ensemble de plusieurs diodes électroluminescentes, chaque diode comportant un empilement vertical d'une première couche semiconductrice d'un premier type de conductivité et d'une deuxième couche semiconductrice du deuxième type de conductivité, et les diodes étant séparées les unes des autres par des tranchées ;
pour chaque diode, une première électrode disposée sur et en contact avec la face de la deuxième couche opposée à la première couche ;
une deuxième électrode commune à ladite pluralité de diodes, la deuxième électrode s'étendant dans les tranchées et à la périphérie de la pluralité de diodes et étant en contact, dans chaque diode, avec la première couche semiconductrice ; et
du côté d'une face du premier circuit opposée à la première couche semiconductrice, une structure de connexion comprenant une couche diélectrique dans laquelle sont disposés une pluralité de plots de connexion identiques ou similaires, régulièrement répartis sur toute la surface du premier circuit, chaque diode ayant sa première électrode en contact avec au moins un plot de la structure de connexion, et la deuxième électrode étant en contact avec plusieurs plots de la structure de connexion en périphérie de la pluralité de diodes.

Selon un mode de réalisation, le dispositif comporte en outre un deuxième circuit intégré formé dans et sur un substrat semiconducteur, le deuxième circuit comportant, pour chaque diode du premier circuit, un plot métallique destiné à être connecté à la première électrode de la diode, et une électrode métallique destinée à être connectée à la deuxième électrode du premier circuit.

Selon un mode de réalisation, les premier et deuxième circuits sont fixés l'un à l'autre par collage direct hybride de façon que chaque première électrode du premier circuit soit connectée électriquement à un plot métallique du deuxième circuit, et que la deuxième électrode du premier circuit soit connectée électriquement à l'électrode du deuxième circuit.

Selon un mode de réalisation, le deuxième circuit comprend une structure de connexion comprenant une couche diélectrique dans laquelle sont disposés une pluralité de plots de connexion identiques ou similaires, régulièrement répartis sur toute la surface du deuxième circuit, chaque plot métallique du deuxième circuit étant en contact avec au moins un plot de connexion de la structure de connexion du deuxième circuit, et l'électrode du deuxième circuit étant en contact avec plusieurs plots de connexion de la structure de connexion du deuxième circuit dans une région périphérique de l'électrode du deuxième circuit.

Selon un mode de réalisation, le deuxième circuit comprend, pour chaque plot métallique du deuxième circuit, une cellule élémentaire de contrôle comportant un ou plusieurs transistors, permettant de contrôler le courant circulant dans la diode correspondante du premier circuit et/ou une tension appliquée aux bornes de la diode correspondante du premier circuit.

Selon un mode de réalisation, le deuxième circuit est réalisé en technologie CMOS.

Selon un mode de réalisation, les diodes du premier circuit sont des diodes au nitrure de gallium.

Selon un mode de réalisation, dans le premier circuit, chaque diode électroluminescente comprend en outre une couche émissive entre les première et deuxième couches semiconductrices de la diode.

Un autre mode de réalisation prévoit un procédé de fabrication d'un dispositif d'affichage tel que défini ci-dessus, dans lequel la formation du premier circuit comprend les étapes successives suivantes :
a) déposer successivement, sur une face d'un substrat de support, un empilement vertical comprenant, dans l'ordre à partir de ladite face du substrat, les première et deuxième couches semiconductrices et une couche métallique ;
b) former, depuis la face de l'empilement opposée au substrat de support, des tranchées traversant ledit empilement sur toute sa hauteur et délimitant les différentes diodes du premier circuit ; et
c) former, dans lesdites tranchées, une métallisation en contact, au niveau de chaque diode, avec la première couche semiconductrice de l'empilement.

Selon un mode de réalisation, l'étape b) comprend une première étape de formation partielle des tranchées jusqu'à un niveau intermédiaire de la première couche semiconductrice, suivie d'une étape de dépôt d'une couche isolante sur les flancs des tranchées, suivie d'une étape de prolongement des tranchées jusqu'à la face inférieure de la première couche semiconductrice.

Selon un mode de réalisation, la métallisation formée à l'étape c) s'étend sur toute la hauteur de la tranchée.

Selon un mode de réalisation, la métallisation formée à l'étape c) s'étend sur une partie seulement de la hauteur des tranchées, jusqu'à un niveau intermédiaire de la première couche semiconductrice, la partie supérieure des tranchées étant comblée par un matériau isolant.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B sont des vues en coupe illustrant de façon schématique et partielle des étapes successives d'un exemple d'un procédé de fabrication d'un dispositif d'affichage émissif à LED ;
les figures 2A et 2B sont des vues en coupe illustrant de façon schématique et partielle des étapes successives d'un exemple d'un procédé de fabrication d'un dispositif d'affichage émissif à LED selon un mode de réalisation ;
les figures 3A, 3B, 3C, 3D, 3E, 3F et 3G sont des vues en coupe illustrant plus en détail des étapes successives d'un exemple d'un procédé de fabrication d'un dispositif d'affichage émissif à LED selon un mode de réalisation ; et
les figures 4A, 4B, 4C, 4D, 4E et 4F sont des vues en coupe illustrant des étapes successives d'un autre exemple d'un procédé de fabrication d'un dispositif d'affichage émissif à LED selon un mode de réalisation.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation d'un circuit intégré de contrôle de LED n'a pas été détaillée, les modes de réalisation décrits étant compatibles avec les structures et procédés de fabrication usuels de tels circuits de contrôle. De plus, la composition et l'agencement des différentes couches d'un empilement actif de LED n'ont pas été détaillés, les modes de réalisation décrits étant compatibles avec les empilements actifs usuels de LED. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les dispositifs et assemblages décrits peuvent être orientés différemment. Sauf précision contraire, les expressions "approximativement", "sensiblement", et "de l'ordre de" signifient à 10 % près, de préférence à 5 % près.

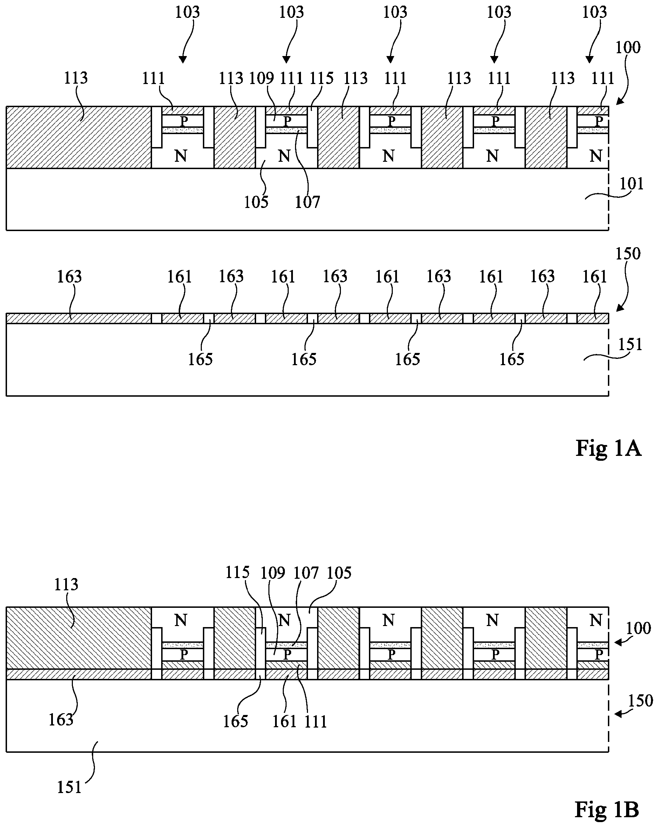

Les figures 1A et 1B sont des vues en coupe illustrant de façon schématique et partielle des étapes successives d'un exemple d'un procédé de fabrication d'un dispositif d'affichage émissif à LED.

La figure 1A illustre une étape initiale au cours de laquelle on fabrique, de manière séparée, un premier circuit intégré 100 comportant une pluralité de LED, et un deuxième circuit intégré 150, correspondant au circuit de contrôle des LED.

Le circuit 100 comprend un substrat de support 101, par exemple en saphir, en silicium, en nitrure de gallium (GaN), ou en tout autre matériau sur lequel un empilement actif de LED peut être déposé. Le circuit 100 comprend en outre une pluralité de LED 103, par exemple identiques ou similaires, disposées sur la face supérieure du substrat de support 101. Vu de dessus, les LED 103 sont par exemple disposées en matrice selon des rangées et des colonnes, par exemple régulièrement réparties sur la face supérieure du substrat 101. Chaque LED 103 comprend un empilement vertical comprenant, dans l'ordre à partir de la face supérieure du substrat 101, une première couche semiconductrice 105 dopée d'un premier type de conductivité, par exemple de type N, une couche émissive 107, et une deuxième couche semiconductrice 109 dopée du deuxième type de conductivité, par exemple de type P. Les couches 105 et 109 sont par exemple en nitrure de gallium. La couche émissive 107 est par exemple constituée par un empilement d'une ou plusieurs couches émissives formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 107 peut être une couche de nitrure de gallium intrinsèque, c'est-à-dire non intentionnellement dopée. Plus généralement, l'homme du métier saura choisir le ou les matériaux de la couche émissive 107 en fonction de la longueur d'onde d'émission souhaitée, par exemple pour une émission dans le domaine visible, dans le domaine ultraviolet, ou dans le domaine infrarouge.

Dans cet exemple, la face inférieure de la couche émissive 107 est en contact avec la face supérieure de la couche 105, et la face supérieure de la couche émissive 107 est en contact avec la face inférieure de la couche 109. En pratique, selon la nature du substrat 101, un empilement d'une ou plusieurs couches tampon (non représentées) peut faire interface entre le substrat de support 101 et la couche semiconductrice 105.

Les LED élémentaires 103 du circuit 100 sont séparées les unes des autres par des tranchées verticales s'étendant, dans cet exemple, sur toute l'épaisseur de l'empilement des couches 105, 107 et 109 et débouchant sur la face supérieure du substrat de support 101 ou, le cas échéant, de la couche tampon (non représentée) séparant le substrat de support 101 de la couche semiconductrice 105. Plus particulièrement, dans cet exemple, les tranchées de séparation des LED forment, vu de dessus, un quadrillage tel que chaque maille du quadrillage comprenne une unique LED 103, et tel que chaque LED 103 soit disposée dans une maille du quadrillage.

Le circuit 100 comprend, pour chaque LED 103, une électrode métallique 111 disposée sur et en contact avec la face supérieure de la couche semiconductrice 109 de la LED. Dans cet exemple, l'électrode 111 s'étend sur toute la surface supérieure de la couche semiconductrice 109 de la LED.

Le circuit 100 comprend de plus une électrode métallique 113 commune à l'ensemble des LED 103. L'électrode 113 s'étend dans les tranchées séparant les LED 103 et à la périphérie de l'ensemble de LED 103. Vu de dessus, l'électrode 113 forme une grille continue telle que chaque maille de la grille contienne une unique LED 103, et tel que chaque LED 103 soit disposée dans une maille de la grille. Dans chaque LED 103, la couche semiconductrice inférieure 105 de la LED est en contact avec l'électrode commune 113. Plus particulièrement, dans l'exemple représenté, dans chaque LED 103, l'électrode 113 est en contact avec une partie inférieure des flancs de la couche semiconductrice 105 de la LED, sur toute la périphérie de la LED. Dans cet exemple, chaque LED 103 comprend en outre, dans une partie supérieure de la LED, un mur d'isolation périphérique 115, en un matériau diélectrique, en contact, sur toute la périphérie de la LED, avec les flancs de l'électrode supérieure 111, de la couche semiconductrice 109 et de la couche émissive 107 de la LED, ainsi qu'avec une partie supérieure des flancs de la couche semiconductrice 105 de la LED. Le mur d'isolation périphérique 115 permet notamment d'isoler électriquement l'électrode 113 de l'électrode 111 et des couches 109 et 107 de la LED.

Dans cet exemple, la face supérieure de l'électrode 113, les faces supérieures des électrodes 109, et les faces supérieures des murs d'isolation 115 sont sensiblement au même niveau (c'est-à-dire sensiblement coplanaires) et définissent une surface continue sensiblement plane, formant la face de connexion du circuit 100. Ainsi, la face de connexion du circuit 100 comprend une alternance de régions métalliques (les électrodes 111 et 113) et de régions diélectriques (les murs d'isolation 115).

Le circuit de contrôle 150 est formé dans et sur un substrat semiconducteur 151, par exemple un substrat en silicium. Dans cet exemple, le circuit de contrôle 150 comprend, du côté de sa face supérieure, pour chacune des LED du circuit 100, un plot métallique de connexion 161 destiné à être connecté à l'électrode 111 de la LED, de façon à pouvoir commander un courant circulant dans la LED et/ou appliquer une tension aux bornes de la LED. Le circuit de contrôle 150 comprend par exemple, pour chaque LED, connectée au plot métallique 161 dédié à la LED, une cellule élémentaire de contrôle (non détaillée) comportant un ou plusieurs transistors, permettant de contrôler le courant circulant dans la LED et/ou une tension appliquée aux bornes de la LED. Le circuit de contrôle 150 est par exemple réalisé en technologie CMOS.

Dans l'exemple représenté, le circuit de contrôle 150 comprend en outre, du côté de sa face supérieure, une électrode métallique 163 destinée à être connectée à l'électrode commune 113 du circuit de LED 100. Chaque cellule élémentaire de contrôle du circuit 150 est par exemple connectée à l'électrode 163.

Dans l'exemple représenté, les plots 161 et l'électrode 163 du circuit intégré 150 ont, en vue de dessus, sensiblement les mêmes dimensions et la même disposition que les électrodes 111 et 113 du circuit de LED 100. Autrement dit, dans cet exemple, vu de dessus, l'électrode 163 forme une grille continue telle que chaque maille de la grille contienne un unique plot 161, et tel que chaque plot 161 soit disposé dans une maille de la grille.

Les plots 161 sont séparés latéralement de l'électrode 163 par un anneau 165 en matériau diélectrique, par exemple de l'oxyde de silicium. Dans cet exemple, les anneaux 165 ont, vu de dessus, sensiblement les mêmes dimensions et la même disposition que les murs d'isolation 115 du circuit 100.

Dans cet exemple, la face supérieure de l'électrode 163, les faces supérieures des plots 161, et les faces supérieures des anneaux d'isolation 165 sont sensiblement au même niveau (c'est-à-dire sensiblement coplanaires) et forment ensemble une surface continue sensiblement plane, formant la face de connexion du circuit 150. Ainsi, la face de connexion du circuit 150 comprend une alternance de régions métalliques (les plots 161 et l'électrode 163) et de régions diélectriques (les régions 165), formant un motif identique ou similaire au motif formé par les régions métalliques et diélectriques de la face de connexion du circuit 100.

La figure 1B illustre une étape postérieure à la réalisation des circuits 100 et 150 de la figure 1B, au cours de laquelle le circuit de LED 100 est rapporté sur le circuit de contrôle 150, face de connexion tournée vers la face de connexion du circuit de contrôle 150. Lors de cette étape, la face de connexion du circuit de LED 100 (à savoir sa face inférieure dans l'orientation de la figure 1B) est fixée à la face de connexion du circuit de contrôle 150 (à savoir sa face supérieure dans l'orientation de la figure 1B) de façon que chaque électrode 111 du circuit de LED 100 soit en contact mécaniquement et électriquement avec un plot métallique 161 du circuit de contrôle 150, et que l'électrode commune 113 du circuit de LED 100 soit en contact mécaniquement et électriquement avec l'électrode 163 du circuit de contrôle 150.

Dans cet exemple, la face de connexion du circuit de LED 100 est fixée à la face de connexion du circuit de contrôle 150 par collage direct hybride, c'est-à-dire par collage direct métal-métal des électrodes 111 du circuit 100 sur les plots de connexion 161 du circuit 150 et de l'électrode 113 du circuit 100 sur l'électrode 163 du circuit 150, et par collage direct diélectrique-diélectrique des murs d'isolation 115 du circuit 100 sur les anneaux isolants 165 du circuit 150. Par collage direct, on entend ici un collage de type moléculaire, sans apport de matière adhésive ou de brasure à l'interface entre le circuit de LED 100 et le circuit de contrôle 150.

La figure 1B illustre en outre une étape postérieure au collage du circuit de LED 100 sur le circuit de contrôle 150, au cours de laquelle le substrat de support 101 du circuit de LED 100 est retiré. Si une couche tampon était prévue entre le substrat de support 101 et la couche semiconductrice 105 du circuit de LED 100, la couche tampon peut également être retirée lors de cette étape, de façon à exposer la face de la couche semiconductrice 105 opposée au circuit de contrôle 150 (à savoir sa face supérieure dans l'orientation de la figure 1B) . Dans cet exemple, le dispositif d'affichage est en effet destiné à émettre de la lumière du côté de sa face opposée au circuit de contrôle 150, à savoir sa face supérieure dans l'orientation de la figure 1B.

La prévision d'un collage direct hybride entre le circuit de LED 100 et le circuit de contrôle 150 est avantageuse en ce qu'elle permet d'obtenir un alignement particulièrement précis du circuit de LED 100 par rapport au circuit de contrôle 150. En effet, dans le cas d'un collage direct, une fois les deux circuits alignés, une simple mise en contact des circuits suffit à figer la position finale du circuit de LED 100 par rapport au circuit de contrôle 150. Autrement dit, le collage est instantané. Ceci constitue une différence par rapport à un collage avec apport de matière, par exemple par brasure, dans lequel une étape de compression et/ou de chauffage doit être mise en oeuvre après l'alignement et la mise en contact des deux circuits, ce qui peut conduire à un désalignement des circuits.

Un problème qui se pose dans le procédé décrit en relation avec les figures 1A et 1B est que le taux d'occupation de la face de connexion du circuit de LED 100 par du métal (et par conséquent le taux d'occupation de la face de connexion du circuit de contrôle 150 par du métal, les faces de connexion des deux circuits étant symétriques) est relativement élevé, typiquement supérieur à 70 %, et par exemple supérieur à 80 %. En effet, la face de connexion du circuit de LED 100 est constituée essentiellement par le métal des électrodes 111 et 113 des LED, le matériau diélectrique des murs d'isolation 115 n'occupant qu'une faible portion de la face de connexion.

De plus, la répartition du métal sur la face de connexion du circuit de LED 100 (et par conséquent la répartition du métal sur la face de connexion du circuit de contrôle 150) n'est pas homogène. En effet, comme cela apparaît sur les figures 1A et 1B, la grille métallique formant l'électrode commune 113 du circuit de LED 100 peut comprendre un cadre périphérique relativement large, par exemple de largeur (distance entre le bord extérieur et le bord intérieur du cadre) supérieure au pas inter-pixels (c'est-à-dire la distance centre à centre entre deux LED 103 voisines) du dispositif, par exemple de largeur supérieure à deux fois le pas inter-pixels du dispositif. Il en résulte que le taux d'occupation de la face de connexion du circuit de LED 100 par du métal est plus élevé à la périphérie de l'ensemble de LED qu'à l'intérieur de la matrice de LED.

Pour obtenir un collage direct hybride de bonne qualité, il serait préférable que le taux d'occupation des faces de connexion des circuits 100 et 150 soit moins élevé, et que la répartition du métal sur les faces de connexion des circuits 100 et 150 soit plus homogène. En effet, préalablement à l'étape de collage proprement dite, les faces de connexion des circuits 100 et 150 sont planarisées par polissage mécano-chimique (CMP). La planéité de surface obtenue lors de cette étape conditionne la qualité du collage direct hybride des deux circuits. Toutefois, pour obtenir une bonne planéité de surface, il est préférable que le taux d'occupation de la face de connexion par du métal soit relativement faible, et que la distribution du métal sur la face de connexion soit la plus homogène possible.

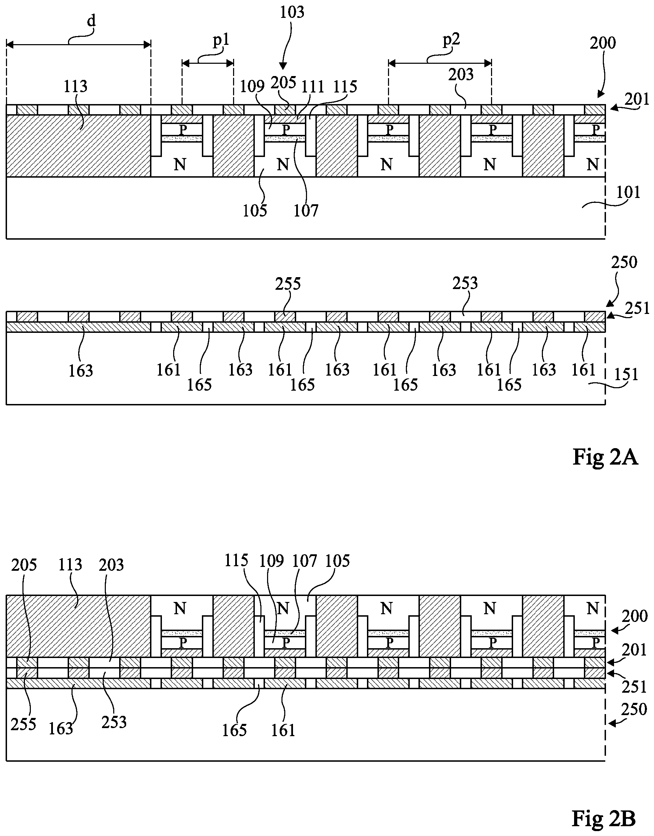

Les figures 2A et 2B sont des vues en coupe illustrant de façon schématique et partielle des étapes successives d'un exemple d'un procédé de fabrication d'un dispositif d'affichage émissif à LED selon un mode de réalisation.

La figure 2A illustre une étape initiale au cours de laquelle on fabrique, de manière séparée, un premier circuit intégré 200 comportant une pluralité de LED, et un deuxième circuit intégré 250, correspondant au circuit de contrôle des LED.

Le circuit de LED 200 de la figure 2A comprend les mêmes éléments que le circuit de LED 100 de la figure 1A, agencés sensiblement de la même manière. Ces éléments ne seront pas détaillés à nouveau ci-après.

Le circuit de LED 200 de la figure 2A diffère du circuit de LED 100 de la figure 1A principalement en ce qu'il comprend en outre, du côté de sa face supérieure, une structure de connexion 201, s'étendant sur sensiblement toute la surface du circuit.

La structure de connexion 201 comprend une couche diélectrique 203 revêtant la face supérieure de l'électrode commune 113, des électrodes individuelles 111, et des murs d'isolation 115 du circuit (correspondant à la face supérieure ou face de connexion du circuit 100 de la figure 1A). A titre d'exemple, la face inférieure de la couche diélectrique 203 est en contact avec la face supérieure de l'électrode commune 113, avec la face supérieure des électrodes individuelles 111, et avec la face supérieure des murs d'isolation 115.

La structure de connexion 201 comprend en outre une pluralité de plots de connexion métalliques élémentaires 205 disjoints, identiques ou similaires, disposés dans des cavités traversantes formées dans la couche diélectrique 203. Les plots de connexion 205 s'étendent verticalement de la face inférieure à la face supérieure de la couche diélectrique 203. Dans cet exemple, la face supérieure de la couche diélectrique 201 et les faces supérieures des plots métalliques 205 sont sensiblement au même niveau (c'est-à-dire sensiblement coplanaires) et définissent une surface continue sensiblement plane, formant la face de connexion du circuit 200. Dans cet exemple, les seuls éléments métalliques visibles en face supérieure de la structure de connexion 201 sont les plots 205. Les plots de connexion 205 sont régulièrement répartis sur toute la surface du circuit 200. En vue de dessus, les plots de connexion 205 sont par exemple disposés en matrice selon des rangées et des colonnes. A titre d'exemple, en vue de dessus, un même motif élémentaire constitué d'un plot 205 entouré par une portion de la couche diélectrique 203 est répété de façon périodique sur toute la surface supérieure du circuit, dans la direction des rangées et des colonnes de la matrice de LED. A titre d'exemple, le pas inter-plots p1 (c'est-à-dire la distance centre à centre entre deux plots 205 voisins de la structure de connexion 201) est sensiblement identique dans la direction des rangées et des colonnes de la matrice, et est sensiblement identique sur toute la surface de la matrice. De préférence, vu de dessus, le taux d'occupation de la structure de connexion 201 par les plots métalliques est compris entre 5 et 50 %, par exemple de l'ordre de 25 %.

Dans chaque LED 103 du circuit de LED 200 de la figure 2A, l'électrode 111 de la LED est en contact, par sa face supérieure, avec la face inférieure d'au moins un plot de contact 205 de la structure de connexion 201. De plus, l'électrode commune 113 du circuit de LED est en contact, en périphérie de l'ensemble de LED 103, avec plusieurs plots 205 de la structure de connexion 201. Dans cet exemple, un même plot 205 de la structure de connexion n'est en contact qu'avec une électrode 111 ou 113 du circuit de LED.

Dans l'exemple représenté, le pas inter-plots p1 de la structure de connexion 201 est inférieur au pas inter-pixels p2 du circuit 200, de façon que, à l'intérieur de l'ensemble de LED 103, l'électrode commune 113 du circuit soit en contact avec des plots 205 de la structure de connexion 201. Les modes de réalisation décrits ne se limitent toutefois pas à ce cas particulier. A titre de variante, le pas inter-plots p1 de la structure de connexion 201 peut être égal ou sensiblement égal au pas inter-pixels p2 du circuit 200, auquel cas l'électrode commune 113 du circuit n'est en contact avec des plots 205 qu'à la périphérie de l'ensemble de LED 103, et non à l'intérieur de l'ensemble de LED 103. Chaque plot de connexion 205 a par exemple, en vue de dessus, une surface inférieure à la surface de l'électrode 111 d'une LED du circuit. A titre d'exemple, le pas inter-pixels p2 du dispositif est compris entre 2 et 30 µm, et la largeur des LED élémentaires est comprise entre 0,5 et 25 pm.

Le circuit de contrôle 250 de la figure 2B est similaire au circuit de contrôle 150 de la figure 1B, à ceci près que, dans l'exemple de la figure 2B, la face de connexion du circuit de contrôle est adaptée pour présenter le même motif métallique et diélectrique que la face de connexion du circuit de LED 200.

A titre d'exemple, le circuit de contrôle 250 de la figure 2B comprend les mêmes éléments que le circuit de contrôle 150 de la figure 1B, agencés sensiblement de la même manière, et comprend en outre, du côté de sa face supérieure, une structure de connexion 251 similaire à la structure de connexion 201 du circuit de LED 200, s'étendant sur sensiblement toute la surface du circuit de contrôle 250.

En particulier, la structure de connexion 251 comprend une couche diélectrique 253 revêtant la face supérieure de l'électrode commune 163, des électrodes individuelles 161, et des anneaux d'isolation 165 du circuit (correspondant à la face supérieure ou face de connexion du circuit 150 de la figure 1A). A titre d'exemple, la face inférieure de la couche diélectrique 253 est en contact avec la face supérieure de l'électrode commune 163, avec la face supérieure des électrodes individuelles 161, et avec la face supérieure des anneaux d'isolation 165.

La structure de connexion 251 comprend en outre une pluralité de plots de connexion métalliques élémentaires 255 disjoints, identiques ou similaires, disposés dans des cavités traversantes formées dans la couche diélectrique 253. Les plots de connexion 255 s'étendent verticalement de la face inférieure à la face supérieure de la couche diélectrique 253. Dans cet exemple, la face supérieure de la couche diélectrique 251 et les faces supérieures des plots métalliques 255 sont sensiblement au même niveau (c'est-à-dire sensiblement coplanaires) et définissent une surface continue sensiblement plane, formant la face de connexion du circuit 250. Dans cet exemple, les seuls éléments métalliques visibles en face supérieure de la structure de connexion 251 sont les plots 255.

En vue de dessus, les dimensions et la répartition des plots de connexion 255 de la structure de connexion 251 du circuit de contrôle 250 sont identiques ou similaires aux dimensions et à la répartition des plots de connexion 205 de la structure de connexion 201 du circuit de LED 200.

Ainsi, chaque plot 161 du circuit de contrôle 250 de la figure 2A est en contact, par sa face supérieure, avec la face inférieure d'au moins un plot de contact 255 de la structure de connexion 251. De plus, la partie périphérique de l'électrode commune 163 du circuit de contrôle 250 est en contact avec plusieurs plots 255 de la structure de connexion 251.

La figure 2B illustre une étape postérieure à la réalisation des circuits 200 et 250 de la figure 2A, au cours de laquelle le circuit de LED 200 est rapporté sur le circuit de contrôle 250, face de connexion tournée vers la face de connexion du circuit de contrôle 250. Lors de cette étape, la face de connexion du circuit de LED 200 (à savoir sa face inférieure dans l'orientation de la figure 2B) est fixée à la face de connexion du circuit de contrôle 250 (à savoir sa face supérieure dans l'orientation de la figure 2B) de façon que chaque plot de connexion 205 du circuit de LED 200 soit en contact mécaniquement et électriquement avec un plot de connexion 255 du circuit de contrôle 250.

Dans cet exemple, la face de connexion du circuit de LED 200 est fixée à la face de connexion du circuit de contrôle 250 par collage direct hybride, c'est-à-dire par collage direct métal-métal des plots de connexion 205 du circuit 200 sur les plots de connexion 255 du circuit 250, et par collage direct diélectrique-diélectrique de la couche diélectrique 203 du circuit 200 sur la couche diélectrique 253 du circuit 250.

La figure 2B illustre en outre une étape postérieure au collage du circuit de LED 200 sur le circuit de contrôle 250, au cours de laquelle le substrat de support 101 du circuit de LED 100, et, le cas échéant, une couche tampon (non représentée) prévue entre le substrat 101 et la couche semiconductrice 105, sont retirés de façon à exposer la face de la couche semiconductrice 105 opposée au circuit de contrôle 250.

Un avantage du mode de réalisation des figures 2A et 2B réside dans la prévision, côté circuit LED 200, d'une structure de connexion 201, et, côté circuit de contrôle 250, d'une structure de connexion correspondante 251, permettant d'obtenir, au niveau des faces de connexion des deux circuits, une répartition des motifs métalliques mieux adaptée à la réalisation d'un collage direct hybride de bonne qualité que la répartition imposée, dans l'exemple des figures 1A et 1B, par les contraintes de distribution du courant et/ou de chaleur dans le circuit LED. En particulier, la structure de connexion 201 permet que le taux d'occupation de la face de connexion du circuit de LED 200 (et par conséquent le taux d'occupation de la face de connexion du circuit de contrôle 250 par du métal) soit inférieur au taux d'occupation par du métal au niveau de la face supérieure des électrodes métalliques 111 et 113 du circuit de LED. De plus, la structure de connexion 201 permet que la répartition du métal sur la face de connexion du circuit de LED 200 (et par conséquent la répartition du métal sur la face de connexion du circuit de contrôle 250) soit plus homogène que la répartition du métal au niveau de la face supérieure des électrodes métalliques 111 et 113 du circuit de LED.

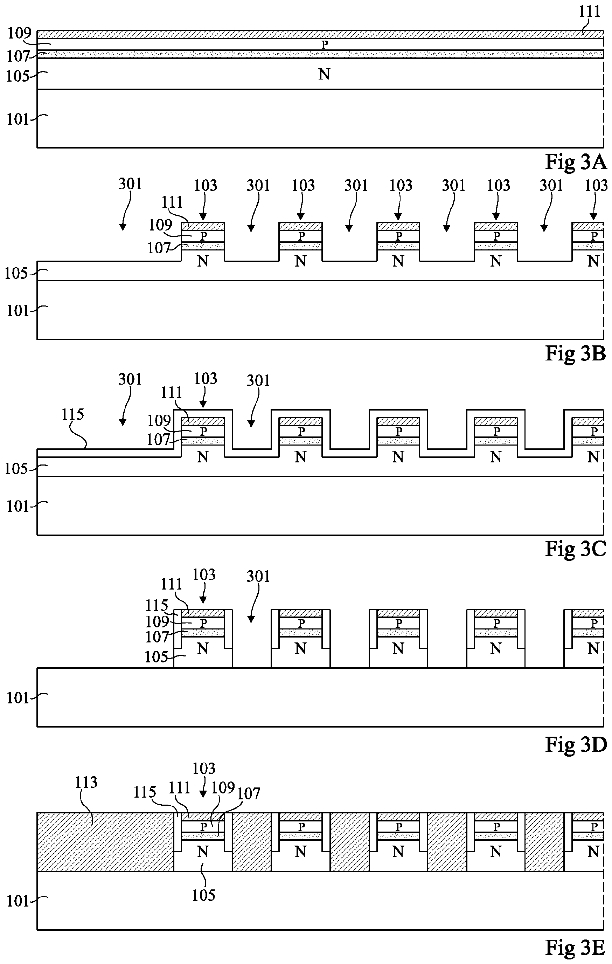

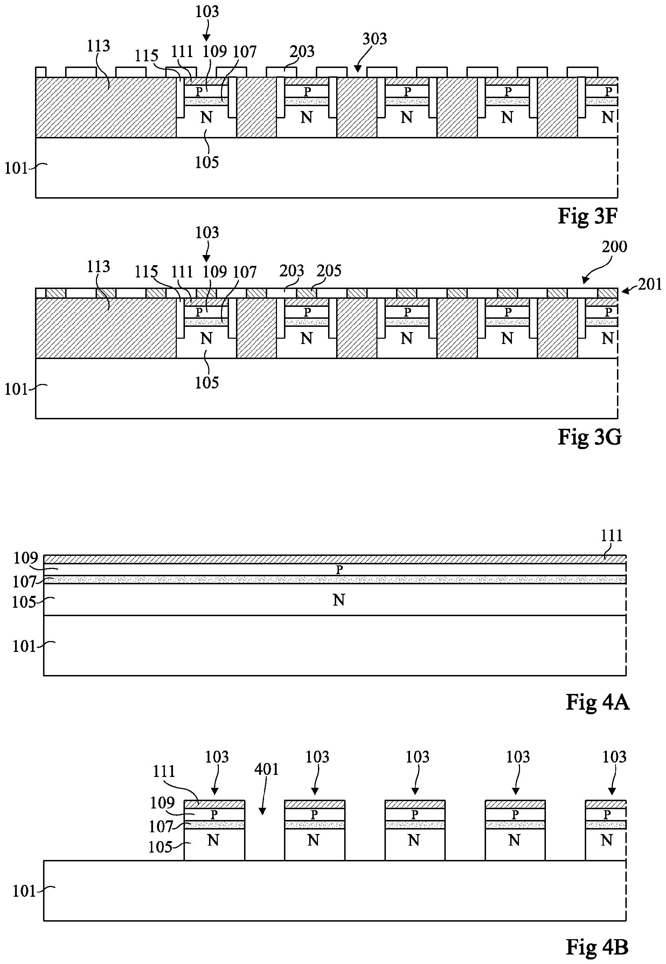

Les figures 3A, 3B, 3C, 3D, 3E, 3F et 3G sont des vues en coupe illustrant plus en détail des étapes successives d'un exemple d'un procédé de fabrication d'un dispositif d'affichage émissif à LED selon un mode de réalisation. Les figures 3A, 3B, 3C, 3D, 3E, 3F et 3G illustrent plus particulièrement des étapes successives d'un exemple d'un procédé de fabrication du circuit de LED 200 décrit en relation avec la figure 2A.

La figure 3A illustre une étape au cours de laquelle on dépose successivement, sur la face supérieure du substrat de support 101, la couche semiconductrice 105, la couche émissive 107 et la couche semiconductrice 109 formant un empilement actif de LED. A ce stade, les couches 105, 107 et 109 s'étendent de façon continue sur sensiblement toute la surface supérieure du substrat de support 101. Les couches 105, 107 et 109 sont par exemple déposées par épitaxie sur la face supérieure du substrat de support 101. En pratique, selon la nature du substrat 101, un empilement d'une ou plusieurs couches tampon (non représentées) peut faire interface entre le substrat de support 101 et la couche semiconductrice inférieure 105.

La figure 3A illustre en outre une étape de dépôt, sur et en contact avec la face supérieure de la couche semiconductrice 109, d'une couche métallique 111 formant une électrode supérieure de l'empilement actif de LED. Dans cet exemple, la couche métallique 111 est déposée de façon continue sur sensiblement toute la surface supérieure de la couche 109. La couche métallique 111 est par exemple déposée par dépôt physique en phase vapeur (PVD). A titre d'exemple, la couche métallique 111 est en cuivre ou en titane.

La figure 3B illustre une étape de formation de tranchées 301 s'étendant verticalement dans l'empilement de couches obtenu à l'issue des étapes de la figure 3A, depuis la face supérieure de l'empilement, c'est-à-dire depuis la face supérieure de la couche métallique 111. Les tranchées 301 traversent entièrement les couches 111, 109 et 107 et s'interrompent à un niveau intermédiaire de la couche semiconductrice inférieure 105. En vue de dessus, les tranchées 301 forment un quadrillage continu délimitant les différentes LED 103 du circuit.

La figure 3C illustre une étape de dépôt d'une couche diélectrique 115, par exemple en oxyde de silicium, sur toute la surface supérieure de la structure obtenue à l'issue des étapes des figures 3A et 3B, c'est-à-dire sur les flancs et sur le fond des tranchées 301 et sur la face supérieure des électrodes supérieures 111 des LED 103. La couche 115 est de préférence déposée par une méthode de dépôt conforme, par exemple par dépôt en couches monoatomiques successives (ALD). A titre d'exemple, l'épaisseur de la couche isolante 115 est comprise entre 10 nm et 1 µm.

La figure 3D illustre une étape de retrait de la couche diélectrique 115 au fond des tranchées 301 et sur la face supérieure des électrodes 111 des LED 103. Lors de cette étape, la couche 115 est conservée sur les parois latérales des tranchées 301. Pour cela, la couche 115 est par exemple gravée par gravure anisotrope verticale.

La figure 3D illustre de plus une étape de retrait, par gravure, des portions de la couche semiconductrice inférieure 105 situées au fond des tranchées 301, de façon à prolonger les tranchées 301 jusqu'à la face supérieure du substrat 101, ou le cas échéant, jusqu'à la face supérieure de la couche tampon faisant interface entre le substrat 101 et la couche semiconductrice 105. A l'issue de cette étape, les différentes LED 103 sont entièrement isolées électriquement les unes des autres par les tranchées 301.

La figure 3E illustre une étape de dépôt d'une métallisation 113, par exemple en cuivre ou en titane, sur les parois latérales et sur le fond des tranchées 301 obtenues à l'issue des étapes de la figure 3D. Dans l'exemple représenté, la métallisation 113 comble entièrement les tranchées 301. A titre d'exemple, la métallisation 113 est réalisée par un procédé de type damascène, comprenant une étape de dépôt d'une couche métallique sur toute la surface supérieure de l'assemblage, sur une épaisseur suffisante pour combler les tranchées 301, suivie d'une étape de polissage mécanochimique de la face supérieure de l'assemblage pour planariser la face supérieure du dispositif et retirer les portions de la couche métallique surmontant les LED 103, jusqu'à exposer la face supérieure des murs d'isolation 115 (de façon à isoler l'électrode commune 113 des électrodes 111).

La figure 3F illustre une étape de dépôt de la couche diélectrique 203 de la structure de connexion 201, sur et en contact avec la face supérieure de la structure obtenue à l'issue des étapes de la figure 3E. La couche diélectrique 203 est par exemple en oxyde de silicium ou en nitrure de silicium. La couche 203 est par exemple déposée par dépôt chimique en phase vapeur (CVD), ou par toute autre méthode de dépôt adaptée. La couche diélectrique 203 est initialement déposée de façon continue sur sensiblement toute la surface supérieure de la structure obtenue à l'issue des étapes de la figure 3E, c'est-à-dire sur la face supérieure des électrodes 113 et 111 et sur la face supérieure des murs d'isolation 115 du circuit.

La figure 3F illustre en outre une étape de gravure localisée de la couche diélectrique 203, pour former dans la couche 203 des ouvertures traversantes 303 débouchant sur les faces supérieures des électrodes 111 et 113 et destinées à contenir les plots de connexion 205 de la structure de connexion 201.

La figure 3G illustre une étape de remplissage des ouvertures 303 par du métal, par exemple du titane ou du cuivre, pour former les plots de connexion 205 de la structure de connexion 201. A titre d'exemple, les plots de connexion 205 sont réalisés par un procédé de type damascène, comprenant une étape de dépôt d'une couche métallique sur toute la surface supérieure de la structure obtenue à l'issue des étapes de la figure 3F, sur une épaisseur suffisante pour combler les ouvertures 303, suivie d'une étape de polissage mécanochimique de la face supérieure de la structure pour planariser la face supérieure du circuit et retirer les portions de la couche métallique surmontant la couche diélectrique 203 entre les ouvertures 303, de façon à isoler les plots de connexion 205 les uns des autres. A l'issue de cette étape, on obtient un circuit de LED 200 identique ou similaire à celui de la figure 2A, dont la face supérieure ou face de connexion est sensiblement plane et comprend une alternance de régions métalliques (les plots 205) et de régions diélectriques (les portions de la couche 203 entourant latéralement les plots 205).

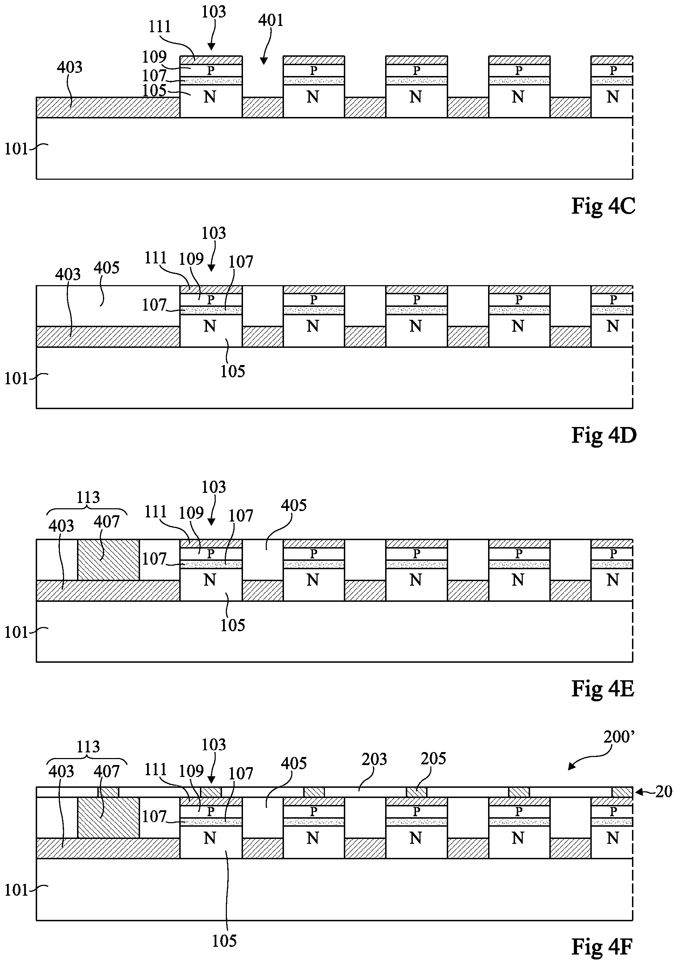

Les figures 4A, 4B, 4C, 4D, 4E et 4F sont des vues en coupe illustrant des étapes successives d'un autre exemple d'un procédé de fabrication d'un dispositif d'affichage émissif à LED selon un mode de réalisation. Les figures 4A, 4B, 4C, 4D, 4E et 4F illustrent plus particulièrement des étapes successives d'un exemple d'un procédé de fabrication d'une variante de réalisation du circuit de LED 200 décrit en relation avec la figure 2A.

La figure 4A illustre une étape identique ou similaire à l'étape décrite en relation avec la figure 3A, au cours de laquelle on dépose successivement, sur la face supérieure du substrat de support 101, la couche semiconductrice 105, la couche émissive 107 et la couche semiconductrice 109, formant un empilement actif de LED, puis la couche métallique d'électrode 111 sur et en contact avec la face supérieure de la couche semiconductrice 109.

La figure 4B illustre une étape de formation de tranchées 401 s'étendant verticalement dans l'empilement de couches obtenu à l'issue des étapes de la figure 4A, depuis la face supérieure de l'empilement, c'est-à-dire depuis la face supérieure de la couche métallique 111. Dans cet exemple, les tranchées 401 traversent entièrement les couches 111, 109, 107 et 105 et s'interrompent sur la face supérieure du substrat de support 101, ou, le cas échéant, sur la face supérieure d'une couche tampon faisant interface entre le substrat 101 et la couche semiconductrice 105. En vue de dessus, les tranchées 401 forment un quadrillage continu délimitant les différentes LED 103 du circuit. On notera que dans cet exemple, les étapes de formation d'un mur d'isolation périphérique 115 en partie supérieure des LED 103, décrites en relation avec les figures 3B, 3C et 3D, ne sont pas prévues. Ainsi, à l'issue de l'étape de formation de tranchées de la figure 4B, les flancs des couches 111, 109, 107 et 105 des LED sont exposés sur toute leur hauteur.

La figure 4C illustre une étape de remplissage partiel des tranchées 401 par une couche métallique 403. Plus particulièrement, dans cet exemple, la couche métallique 403 comble le fond des tranchées, jusqu'à un niveau inférieur à la face supérieure de la couche semiconductrice 105. Autrement dit, dans chaque LED 103, la couche métallique 403 est en contact avec une partie inférieure des flancs de la couche semiconductrice 105 de la LED, sur toute la périphérie de la LED. La couche métallique 403 n'est en revanche pas en contact avec la partie supérieure des flancs de la couche 105, ni avec les flancs des couches 107, 109 et 111 des LED 103.

La figure 4D illustre une étape au cours de laquelle on finit de remplir les tranchées 401 par un matériau isolant 405, par exemple de l'oxyde de silicium. A titre d'exemple, une couche du matériau isolant 405 est déposée sur toute la surface supérieure de la structure obtenue à l'issue des étapes de la figure 4C, c'est-à-dire sur et en contact avec la face supérieure de la couche métallique 403, sur et en contact avec la partie supérieure des flancs de la couche 105 et les flancs des couches 107, 109 et 111 des LED 103, et sur et en contact avec la face supérieure des électrodes 111 des LED 103. A titre d'exemple, la couche du matériau 405 est déposée sur une épaisseur supérieure à la profondeur de la partie supérieure des tranchées 401 non remplie par la couche métallique 403, de façon à combler entièrement les tranchées 401, puis une étape de polissage mécano-chimique est mise en oeuvre pour planariser la face supérieure de la structure et exposer la face supérieure des électrodes 111 des LED 103.

La figure 4E illustre une étape de reprise d'un contact électrique sur la couche métallique 403. Pour cela, on forme d'abord dans la couche isolante 405, depuis sa face supérieure, une ouverture traversante débouchant sur la face supérieure de la couche métallique 413, par exemple en périphérie de l'ensemble de LED 103 du circuit. L'ouverture est ensuite remplie d'un métal 407, par exemple par un procédé de type damascène, de façon à ramener le contact au niveau de la face supérieure du circuit. Dans l'exemple représenté, la métallisation de reprise de contact 407 est disposée en périphérie de l'ensemble de LED 103 et entoure entièrement l'ensemble de LED 103, mais ne s'étend pas à l'intérieur de l'ensemble de LED 103. A titre de variante, la métallisation de reprise de contact 407 peut avoir un motif en forme de grille, similaire à celui de la couche métallique 403, s'étendant non seulement en périphérie de l'ensemble de LED 103 mais aussi à l'intérieur de l'ensemble de LED 103, entre des LED voisines du circuit. A l'issue de cette étape, les métallisations 403 et 407 définissent l'électrode commune 113 du circuit de LED.

La figure 4F illustre une étape de dépôt de la couche diélectrique 203 de la structure de connexion 201, sur et en contact avec la face supérieure de la structure obtenue à l'issue des étapes de la figure 4E, puis de formation des plots de connexion métalliques 205 dans la couche diélectrique 203, de façon similaire à ce qui a été décrit en relation avec les figures 3F et 3G (formation d'ouvertures traversantes débouchant sur les faces supérieures des métallisations 111 et 407, et remplissage des ouvertures par du métal pour former les plots 205).

A l'issue de cette étape, on obtient un circuit de LED 200' similaire au circuit 200 de la figure 2A, à la différence près que, dans le circuit 200', un isolant 405 plus épais que les murs d'isolation périphériques 115 du circuit 200 sépare les LED 103 les unes des autres.

Des modes de réalisation particuliers ont été décrits. Diverses variantes et modifications apparaîtront à l'homme de l'art. En particulier, les modes de réalisation décrits ne se limitent pas à l'exemple particulier décrit ci-dessus dans lequel les LED du dispositif sont à base de nitrure de gallium. Plus généralement, les modes de réalisation décrits peuvent être appliqués à toute autre technologie de LED.

## Revendications

1. Dispositif d'affichage comprenant un premier circuit intégré (200 ; 200') comportant :
un ensemble de plusieurs diodes électroluminescentes (103), chaque diode comportant un empilement vertical d'une première couche semiconductrice (105) d'un premier type de conductivité et d'une deuxième couche semiconductrice (109) du deuxième type de conductivité, et les diodes étant séparées les unes des autres par des tranchées (301 ; 401) ;
pour chaque diode, une première électrode (111) disposée sur et en contact avec la face de la deuxième couche (109) opposée à la première couche (105) ;
une deuxième électrode (113) commune à ladite pluralité de diodes, la deuxième électrode s'étendant dans les tranchées (301 ; 401) et à la périphérie de la pluralité de diodes et étant en contact, dans chaque diode, avec la première couche semiconductrice (105) ; et
du côté d'une face du premier circuit opposée à la première couche semiconductrice (105), une structure de connexion (201) comprenant une couche diélectrique (203) dans laquelle sont disposés une pluralité de plots de connexion (205) identiques ou similaires, régulièrement répartis sur toute la surface du premier circuit, chaque diode (103) ayant sa première électrode (111) en contact avec au moins un plot (205) de la structure de connexion (201), et la deuxième électrode (113) étant en contact avec plusieurs plots (205) de la structure de connexion (201) en périphérie de la pluralité de diodes.

2. Dispositif selon la revendication 1, comportant en outre un deuxième circuit intégré (250) formé dans et sur un substrat semiconducteur (151), le deuxième circuit comportant, pour chaque diode du premier circuit (200), un plot métallique (161) destiné à être connecté à la première électrode (111) de la diode, et une électrode métallique (163) destinée à être connectée à la deuxième électrode (113) du premier circuit (200 ; 200').

3. Dispositif selon la revendication 2, dans lequel les premier (200 ; 200') et deuxième (250) circuits sont fixés l'un à l'autre par collage direct hybride de façon que chaque première électrode (111) du premier circuit (200 ; 200') soit connectée électriquement à un plot métallique (161) du deuxième circuit (250), et que la deuxième électrode (113) du premier circuit (200 ; 200') soit connectée électriquement à l'électrode métallique (163) du deuxième circuit (250).

4. Dispositif selon la revendication 2 ou 3, dans lequel le deuxième circuit (250) comprend une structure de connexion (251) comprenant une couche diélectrique (253) dans laquelle sont disposés une pluralité de plots de connexion (255) identiques ou similaires, régulièrement répartis sur toute la surface du deuxième circuit, chaque plot métallique (161) du deuxième circuit étant en contact avec au moins un plot de connexion (255) de la structure de connexion (251) du deuxième circuit (250), et l'électrode métallique (163) du deuxième circuit étant en contact avec plusieurs plots de connexion (255) de la structure de connexion (251) du deuxième circuit (250) dans une région périphérique de l'électrode (163) du deuxième circuit.

5. Dispositif selon l'une quelconque des revendications 2 à 4, dans lequel le deuxième circuit (250) comprend, pour chaque plot métallique (161) du deuxième circuit, une cellule élémentaire de contrôle comportant un ou plusieurs transistors, permettant de contrôler le courant circulant dans la diode (103) correspondante du premier circuit et/ou une tension appliquée aux bornes de la diode (103) correspondante du premier circuit.

6. Dispositif selon l'une quelconque des revendications 2 à 5, dans lequel le deuxième circuit (250) est réalisé en technologie CMOS.

7. Dispositif selon l'une quelconque des revendications 1 à 6, dans lequel les diodes (103) du premier circuit (200 ; 200') sont des diodes au nitrure de gallium.

8. Dispositif selon l'une quelconque des revendications 1 à 7, dans lequel, dans le premier circuit (200 ; 200'), chaque diode électroluminescente (103) comprend en outre une couche émissive (107) entre les première (105) et deuxième (109) couches semiconductrices de la diode.

9. Dispositif selon l'une quelconque des revendications 1 à 8, dans lequel le pas inter-plots (p1) de la structure de connexion (201) du premier circuit intégré (200) est inférieur au pas inter-diodes (p2) du premier circuit intégré (200), de façon que, à l'intérieur de l'ensemble de diodes (103) du premier circuit intégré (200), la deuxième électrode (113) commune à ladite pluralité de diodes soit en contact avec des plots (205) de la structure de connexion (201) du premier circuit intégré (200) .

10. Dispositif selon l'une quelconque des revendications 1 à 9, dans lequel les plots (205) de la structure de connexion (201) du premier circuit intégré (200) sont disposés en matrice selon des rangées et des colonnes, selon un pas inter-plots (p1) sensiblement constant dans la direction des rangées et des colonnes de la matrice.

11. Dispositif selon l'une quelconque des revendications 1 à 10, dans lequel les plots de connexion (205) de la structure de connexion (201) du premier circuit intégré (200) sont disposés dans des cavités traversantes formées dans la couche diélectrique (203) de la structure de connexion (201) du premier circuit intégré (200).

12. Procédé de fabrication d'un dispositif d'affichage selon l'une quelconque des revendications 1 à 11, dans lequel la formation du premier circuit (200 ; 200') comprend les étapes successives suivantes :
a) déposer successivement, sur une face d'un substrat de support (101), un empilement vertical comprenant, dans l'ordre à partir de ladite face du substrat, les première (105) et deuxième (109) couches semiconductrices et une couche métallique (111) ;
b) former, depuis la face de l'empilement opposée au substrat de support (101), des tranchées (301 ; 401) traversant ledit empilement sur toute sa hauteur et délimitant les différentes diodes (103) du premier circuit ; et
c) former, dans lesdites tranchées (301 ; 401), une métallisation en contact, au niveau de chaque diode (103), avec la première couche semiconductrice (105) de l'empilement.

13. Procédé selon la revendication 12, dans lequel l'étape b) comprend une première étape de formation partielle des tranchées (301) jusqu'à un niveau intermédiaire de la première couche semiconductrice (105), suivie d'une étape de dépôt d'une couche isolante (115) sur les flancs des tranchées (301), suivie d'une étape de prolongement des tranchées jusqu'à la face inférieure de la première couche semiconductrice (105).

14. Procédé selon la revendication 13, dans lequel la métallisation formée à l'étape c) s'étend sur toute la hauteur de la tranchée (301).

15. Procédé selon la revendication 12, dans lequel la métallisation formée à l'étape c) s'étend sur une partie seulement de la hauteur des tranchées (401), jusqu'à un niveau intermédiaire de la première couche semiconductrice (105), la partie supérieure des tranchées (401) étant comblée par un matériau isolant (405).

## Patentansprüche

1. Eine Anzeigevorrichtung mit einer ersten integrierten Schaltung (200; 200'), wobei die Vorrichtung Folgendes aufweist:
eine Anordnung aus einer Vielzahl von lichtemittierenden Dioden (103), wobei jede Diode einen vertikalen Stapel aus einer ersten Halbleiterschicht (105) eines ersten Leitfähigkeitstyps und einer zweiten Halbleiterschicht (109) des zweiten Leitfähigkeitstyps aufweist und die Dioden durch Gräben (301; 401) voneinander getrennt sind;
für jede Diode eine erste Elektrode (111), die oben auf und in Kontakt mit der Oberfläche der zweiten Schicht (109) gegenüber der ersten Schicht (105) angeordnet ist;
eine zweite Elektrode (113), die der Vielzahl von Dioden gemeinsam ist, wobei sich die zweite Elektrode in den Gräben (301; 401) und an der Peripherie der Vielzahl von Dioden erstreckt und in jeder Diode in Kontakt mit der ersten Halbleiterschicht (105) ist; und
auf der Seite einer Oberfläche der ersten Schaltung, die der ersten Halbleiterschicht (105) gegenüberliegt, eine Verbindungsstruktur (201), die eine dielektrische Schicht (203) mit einer Vielzahl von identischen oder ähnlichen Anschlussflächen (205) aufweist, die regelmäßig über die gesamte Oberfläche der ersten Schaltung verteilt sind, angeordnet sind, wobei jede Diode (103) mit ihrer ersten Elektrode (111) in Kontakt mit mindestens einer Anschlussfläche (205) der Verbindungsstruktur (201) steht, und die zweite Elektrode (113) in Kontakt mit einer Vielzahl von Anschlussflächen (205) der Verbindungsstruktur (201) an der Peripherie der Vielzahl von Dioden steht.

2. Vorrichtung nach Anspruch 1, die ferner eine zweite integrierte Schaltung (250) aufweist, die innerhalb eines Halbleitersubstrats (151) und auf diesem ausgebildet ist, wobei die zweite Schaltung für jede Diode der ersten Schaltung (200) eine Metallfläche bzw. ein Metallpad (161), die mit der ersten Elektrode (111) der Diode verbunden werden soll, und eine Metallelektrode (163), die mit der zweiten Elektrode (113) der ersten Schaltung (200; 200') verbunden werden soll, aufweist.

3. Vorrichtung nach Anspruch 2, wobei die erste (200; 200') und die zweite (250) Schaltung durch direktes Hybrid-Bonden miteinander verbunden sind, so dass jede erste Elektrode (111) der ersten Schaltung (200; 200') elektrisch mit einem Metallpad (161) der zweiten Schaltung (250) verbunden ist und derart, dass die zweite Elektrode (113) der ersten Schaltung (200; 200') elektrisch mit der Metallelektrode (163) der zweiten Schaltung (250) verbunden ist.

4. Vorrichtung nach Anspruch 2 oder 3, wobei die zweite Schaltung (250) eine Verbindungsstruktur (251) aufweist, die eine dielektrische Schicht (253) mit einer Vielzahl identischer oder ähnlicher Anschlussflächen (255) aufweist, die regelmäßig über die gesamte Oberfläche der zweiten Schaltung verteilt sind und darin angeordnet sind, wobei jedes Metallpad (161) der zweiten Schaltung mit mindestens einer Anschlussfläche (255) der Verbindungsstruktur (251) der zweiten Schaltung (250) in Kontakt steht und die Metallelektrode (163) der zweiten Schaltung mit einer Vielzahl von Anschlussflächen (255) der Verbindungsstruktur (251) der zweiten Schaltung (250) in einem peripheren Bereich der Elektrode (163) der zweiten Schaltung in Kontakt steht.

5. Vorrichtung nach einem der Ansprüche 2 bis 4, wobei die zweite Schaltung (250) für jede Metallfläche (161) der zweiten Schaltung eine elementare Steuerzelle mit einem oder mehreren Transistoren aufweist, die es ermöglicht, den durch die entsprechende Diode (103) der ersten Schaltung fließenden Strom und/oder eine an die entsprechende Diode (103) der ersten Schaltung angelegte Spannung zu steuern.

6. Vorrichtung nach einem der Ansprüche 2 bis 5, wobei die zweite Schaltung (250) in CMOS-Technologie hergestellt ist.

7. Vorrichtung nach einem der Ansprüche 1 bis 6, wobei die Dioden (103) der ersten Schaltung (200; 200') Galliumnitriddioden sind.

8. Vorrichtung nach einem der Ansprüche 1 bis 7, wobei in der ersten Schaltung (200; 200') jede lichtemittierende Diode (103) ferner eine emittierende Schicht (107) zwischen der ersten (105) und der zweiten (109) Halbleiterschicht der Diode aufweist.

9. Vorrichtung nach einem der Ansprüche 1 bis 8, wobei der Abstand zwischen Pixeln (p1) der Verbindungsstruktur (201) der ersten integrierten Schaltung (200) kürzer ist als der Abstand zwischen Dioden (p2) der ersten integrierten Schaltung (200), so dass innerhalb der Diodenanordnung (103) der ersten integrierten Schaltung (200) die zweite Elektrode (113), die der Vielzahl von Dioden gemeinsam ist, in Kontakt mit Anschlussflächen (205) der Verbindungsstruktur (201) der ersten integrierten Schaltung (200) ist.

10. Vorrichtung nach einem der Ansprüche 1 bis 9, wobei die Anschlussflächen (205) der Verbindungsstruktur (201) der ersten integrierten Schaltung (200) in einem Array aus Zeilen und Spalten angeordnet sind, entsprechend einem im Wesentlichen konstanten Abstand zwischen Pixeln (p1) in der Zeilen- und Spaltenrichtung des Arrays.

11. Vorrichtung nach einem der Ansprüche 1 bis 10, wobei die Anschlussflächen (205) der Anschlussstruktur (201) der ersten integrierten Schaltung (200) in durchgehenden Hohlräumen angeordnet sind, die in der dielektrischen Schicht (203) der Anschlussstruktur (201) der ersten integrierten Schaltung (200) ausgebildet sind.

12. Ein Verfahren zur Herstellung der Anzeigevorrichtung nach einem der Ansprüche 1 bis 11, wobei das Ausbilden der ersten Schaltung (200; 200') die folgenden aufeinanderfolgenden Schritte aufweist:
a) aufeinanderfolgendes Abscheiden eines vertikalen Stapels auf einer Oberfläche eines Trägersubstrats (101), der in der Reihenfolge von der oberen Oberfläche des Substrats aus die erste (105) und die zweite (109) Halbleiterschicht und eine Metallschicht (111) aufweist;
b) Ausbilden von Gräben (301; 401) von der dem Trägersubstrat (101) gegenüberliegenden Oberfläche des Stapels aus, die den Stapel über seine gesamte Höhe durchqueren und die verschiedenen Dioden (103) der ersten Schaltung abgrenzen; und
c) Ausbilden einer Metallisierung in den Gräben (301; 401) in Kontakt mit der ersten Halbleiterschicht (105) des Stapels auf der Höhe jeder Diode (103).

13. Verfahren nach Anspruch 12, wobei Schritt b) einen ersten Schritt des teilweisen Ausbildens der Gräben (301) bis hinunter zu einem Zwischenniveau der ersten Halbleiterschicht (105) aufweist, gefolgt von einem Schritt des Aufbringens einer Isolierschicht (115) an den Seiten der Gräben (301), gefolgt von einem Schritt der Ausdehnung der Gräben bis hinunter zur unteren Oberfläche der ersten Halbleiterschicht (105).

14. Verfahren nach Anspruch 13, wobei sich die in Schritt c) gebildete Metallisierung über die gesamte Höhe des Grabens (301) erstreckt.

15. Verfahren nach Anspruch 12, wobei sich die in Schritt c) gebildete Metallisierung nur entlang eines Teils der Höhe der Gräben (401) bis zu einem Zwischenniveau der ersten Halbleiterschicht (105) erstreckt, wobei der obere Teil der Gräben (401) mit einem isolierenden Material (405) gefüllt ist.

## Claims

1. A display device comprising a first integrated circuit (200; 200') comprising:
an assembly of a plurality of light-emitting diodes (103), each diode comprising a vertical stack of a first semiconductor layer (105) of a first conductivity type and of a second semiconductor layer (109) of the second conductivity type, and the diodes being separated from one another by trenches (301; 401);
for each diode, a first electrode (111) arranged on top of and in contact with the surface of the second layer (109) opposite to the first layer (105);
a second electrode (113) common to said plurality of diodes, the second electrode extending in the trenches (301; 401) and at the periphery of the plurality of diodes and being in contact, in each diode, with the first semiconductor layer (105); and
on the side of a surface of the first circuit opposite to the first semiconductor layer (105), a connection structure (201) comprising a dielectric layer (203) having a plurality of identical or similar connection pads (205), regularly distributed across the entire surface of the first circuit, arranged therein, each diode (103) having its first electrode (111) in contact with at least one pad (205) of thee connection structure (201), and the second electrode (113) being in contact with a plurality of pads (205) of the connection structure (201) at the periphery of the plurality of diodes.

2. The device according to claim 1, further comprising a second integrated circuit (250) formed inside and on top of a semiconductor substrate (151), the second circuit comprising, for each diode of the first circuit (200), a metal pad (161) intended to be connected to the first electrode (111) of the diode, and a metal electrode (163) intended to be connected to the second electrode (113) of the first circuit (200; 200').

3. The device according to claim 2, wherein the first (200; 200') and second (250) circuits are bonded to each other by direct hybrid bonding so that each first electrode (111) of the first circuit (200; 200') is electrically connected to a metal pad (161) of the second circuit (250) and so that the second electrode (113) of the first circuit (200; 200') is electrically connected to the metal electrode (163) of the second circuit (250).

4. The device according to claim 2 or 3, wherein the second circuit (250) comprises a connection structure (251) comprising a dielectric layer (253) having a plurality of identical or similar connection pads (255), regularly distributed across the entire surface of the second circuit, arranged therein, each metal pad (161) of the second circuit being in contact with at least one connection pad (255) of the connection structure (251) of the second circuit (250), and the metal electrode (163) of the second circuit being in contact with a plurality of connection pads (255) of the connection structure (251) of the second circuit (250) in a peripheral region of the electrode (163) of the second circuit.

5. The device according to any of claims 2 to 4, wherein the second circuit (250) comprises, for each metal pad (161) of the second circuit, an elementary control cell comprising one or a plurality of transistors, enabling to control the current flowing through the corresponding diode (103) of the first circuit and/or a voltage applied across the corresponding diode (103) of the first circuit.

6. The device according to any of claims 2 to 5, wherein the second circuit (250) is made in CMOS technology.

7. The device according to any of claims 1 to 6, wherein the diodes (103) of the first circuit (200; 200') are gallium nitride diodes.

8. The device according to any of claims 1 to 7, wherein, in the first circuit (200; 200'), each light-emitting diode (103) further comprises an emissive layer (107) between the first (105) and second (109) semiconductor layers of the diode.

9. The device according to any of claims 1 to 8, wherein the pitch between pixels (p1) of the connection structure (201) of the first integrated circuit (200) is shorter than the pitch between diodes (p2) of the first integrated circuit (200), so that, within the diode assembly (103) of the first integrated circuit (200), the second electrode (113) common to said plurality of diodes is in contact with pads (205) of the connection structure (201) of the first integrated circuit (200).

10. The device according to any of claims 1 to 9, wherein the pads (205) of the connection structure (201) of the first integrated circuit (200) are arranged in an array of rows and columns, according to a substantially constant pitch between pixels (p1) in the row and column direction of the array.

11. The device according to any of claims 1 to 10, wherein the connection pads (205) of the connection structure (201) of the first integrated circuit (200) are arranged in through cavities formed in the dielectric layer (203) of the connection structure (201) of the first integrated circuit (200).

12. A method of manufacturing the display device according to any of claims 1 to 11, wherein the forming of the first circuit (200; 200') comprises the successive steps of:
a) successively depositing, on a surface of a support substrate (101), a vertical stack comprising, in the order from said upper surface of the substrate, the first (105) and second (109) semiconductor layers and a metal layer (111);
b) forming, from the surface of the stack opposite to the support substrate (101), trenches (301; 401) crossing said stack across its entire height and delimiting the different diodes (103) of the first circuit; and
c) forming, in said trenches (301; 401), a metallization in contact, at the level of each diode (103), with the first semiconductor layer (105) of the stack.

13. The method according to claim 12, wherein step b) comprises a first step of partial forming of the trenches (301) down to an intermediate level of the first semiconductor layer (105), followed by a step of deposition of an insulating layer (115) on the sides of the trenches (301), followed by a step of extension of the trenches down to the lower surface of the first semiconductor layer (105).

14. The method according to claim 13, wherein the metallization formed at step c) extends all along the height of the trench (301).

15. The method according to claim 12, wherein the metallization formed at step c) extends along a portion only of the height of the trenches (401), up to an intermediate level of the first semiconductor layer (105), the upper portion of the trenches (401) being filled with an insulating material (405).
